# EUROPEAN PATENT APPLICATION

(11) **EP 0 942 453 A2**
(43) Date of publication of application: **15.09.1999**
(21) Application number: 99301573.4
(22) Date of filing: 02.03.1999
(51) Int. Cl.: H01J 37/32

(54) **Monitoring of plasma constituents using optical emission spectroscopy**

(30) Priority: 11.03.1998 US 38248
(71) Applicant: EATON CORPORATION, Cleveland, Ohio 44114-2584 (US)
(72) Inventor: Stejic, George, Franklin, Wisconsin 53132 (US); Graf, Michael Anthony, Cambridge, Massachusetts 02138 (US)
(74) Representative: Burke, Steven David

(57) **Abstract**

Method and apparatus for use in treating a workpiece implantation surface by causing ions to impact the workpiece implantation surface. An implantation chamber (12, 112, 212) defines a chamber interior into which one or more workpieces can be inserted. A support (30, 216) positions one or more workpieces within an interior region of the implantation chamber so that implantation surfaces of the workpieces are facing the interior region. A dopant material in the form of a gas is injected into the implantation chamber to cause the gas to occupy a region of the implantation chamber in close proximity to the one or more workpieces. A plasma of implantation material is created within the interior region of the implantation chamber. Characteristics of the ion plasma are determined from an optical analysis of the plasma using optical spectroscopy. By supplying the data (185) from the optical spectroscopy to a database analysis tool executing on a computer (190), the relative concentration of constituent components of the plasma are determined.

## Description

### Field of the Invention

The present invention concerns a workpiece treatment system that uses positively charged ions for treating a workpiece. One such system immerses one or more silicon wafers in a plasma containing positively charged ions that are then accelerated against the surface of the wafers to implant a controlled concentration of the ions into the wafers.

### Background Art

Commercially available ion implantation systems employ an ion source that includes a source chamber spaced from an implantation chamber where one or more workpieces are treated by ions from the source. An exit opening in the source chamber allows ions to exit the source so they can be shaped, analyzed, and accelerated to form an ion beam. The ion beam is directed along an evacuated beam path to the ion implantation chamber where the ion beam strikes one or more workpieces, typically generally circular wafers. The energy of the ion beam is sufficient to cause ions which strike the wafers to penetrate those wafers in the implantation chamber. In a typical application of such a system the wafers are silicon wafers and the ions are used to "dope" the wafers to create a semiconductor material. Selective implantation with the use of masks and passivation layers allows an integrated circuit to be fabricated.

United States Patent 4,764,394 to Conrad entitled "Method and Apparatus for Plasma Source Ion Implantation" discloses an ion implantation system for treating a target by means of ionic bombardment. Ion implantation into surfaces of a three dimensional target is achieved by forming an ionized plasma about the target within an enclosing chamber. Once the plasma is set up in a region surrounding the target, ions from the plasma are driven into the target object from all sides without need to manipulate the target. This implantation is accomplished by application of repetitive pulses of high voltage, typically 20 kilovolts or higher, that cause the ions to be driven into exposed surfaces of the target. A technique discussed in the '394 patent for setting up the plasma is to introduce a neutral gas into the region of the target and then ionize the gas with ionizing radiation.

The system disclosed in the '394 patent to Conrad uses an ion source to create an ion plasma in a region surrounding a workpiece and then selectively pulses an electrode that supports the workpiece thereby attracting the positive ions in the plasma toward the workpiece.

United States patent no. 5,654,043 to Shao et al also concerns a system for treating a workpiece surface by causing ions to impact the workpiece surface. A gas is injected into an implantation chamber so that an ionizable gas occupies a region in close proximity to the workpiece surface. A plasma of implantation material is created within the interior region of the implantation chamber by repeatedly relatively biasing conductive electrodes with a sequence of pulses that both ionize the gas molecules injected into the chamber and accelerate the ionized gas molecules toward the implantation surfaces of the one or more workpieces. The disclosure of the '043 patent to Shao et al. is incorporated herein by reference.

United States patent no. 5,554,854 to Blake entitled "In Situ Removal of Contaminants from the interior Surfaces of an Ion Beam Implanter" discloses an implanter for flat panel displays. In one embodiment, a source chamber creates an ion plasma which exits from the source chamber through apertures in the source chamber to form an ion beam for treating panels within a process chamber. The disclosure of the '854 patent to Blake is incorporated herein by reference.

United States patent number 5,658,423 to Angell et al concerns a method of monitoring the status of a plasma in a chamber while conducting an etch process. Spectral analysis data is collected during etching, with the spectral data characterizing an emission of light from an etch species contained in the plasma.

### Disclosure of the Invention

The present invention concerns an ion implantation system and more specifically to a system for controlling a parameter of a ion plasma used for ion implantation. One exemplary embodiment of the invention is used in calibrating an ion implantation process and includes the step of producing a concentration of ions in an ion source chamber and performing a mass analysis of the concentration of ions and recording mass analysis data. The process also includes the step of performing an optical analysis of the concentration of ions within the ion source chamber and recording the optical analysis data. A database of records based upon this data gathering is stored on a storage medium for a given concentration of ions in the ion source chamber.

Most typically, the ion plasma within the source chamber is created by injecting an ionizable gas into the source chamber. In this embodiment the steps of performing the mass analysis and performing the optical analysis are performed for different concentrations of the ionizable gas. One application for the invention is for use with a system where mass analysis of the constiuents of the ion plasma is not possible but where optical analysis can be performed. In such a system the optical analysis data for the ion plasma can be gathered and is then used to adjust the operating parameter of the system based on a correlation with data stored in a database.

A somewhat different application of optical analysis data can be used without resort to a correlation to mass analysis data. By comparing optical analysis data taken at different intervals the constituent components of the ion plasma chamber are monitored. This application of the invention can be used, for example, during changeover of plasma source materials to determine when it is appropriate to begin use of a second material as an implant ion. A further application of this aspect of the invention is use of optical analysis to detect contamination within a source chamber to control when to perform a cleaning of the chamber.

These and other objects, advantages, and features of the invention will be better understood from the accompanying detailed description of a preferred embodiment of the invention when reviewed in conjunction with the accompanying drawings.

### Brief Description of the Drawings

Figures 1 and 2 are schematic section and perspective views depicting an ion implantation system constructed in accordance with a preferred embodiment of the present invention;
Figure 3 is a schematic depiction of the physical processes that occur at an implantation surface of a workpiece;
Figures 4 and 5 are flowcharts of a process for calibrating the ion implantation system such as the system depicted in Figures 1 and 2;
Figure 6 is a schematic depiction of a mass analyser for calibrating operation of the ion implantation systems of Figures 1 and 2;
Figure 7 is a graph showing optical emission spectra intensity as a function of wavelength for different ions and molecules present in an ion source plasma; and
Figure 8 is a graph showing peaks in atomic mass as a function of intensity for ions emitted from a plasma source;
Figure 9 is a graph showing predicted fractions of ion plasma constituents as percentage versus actual measured percentages;
Figure 10 is a scehematic depiction of a low energy ion implanter;
Figure 11 is a graph showing optical emission spectroscopy data used in monitoring particle constituent components within an ion source chamber; and
Figure 12 is a graph comparing data taken during a changeover in plasma constituents in an ion implanter source chamber.

### Best Mode for Practicing the Invention

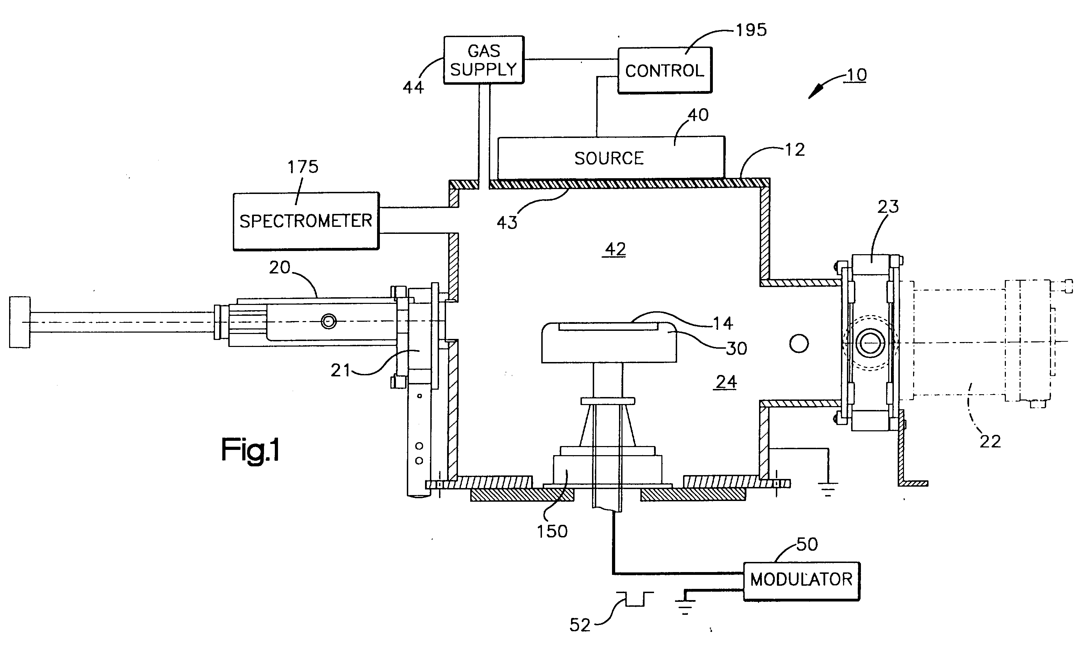

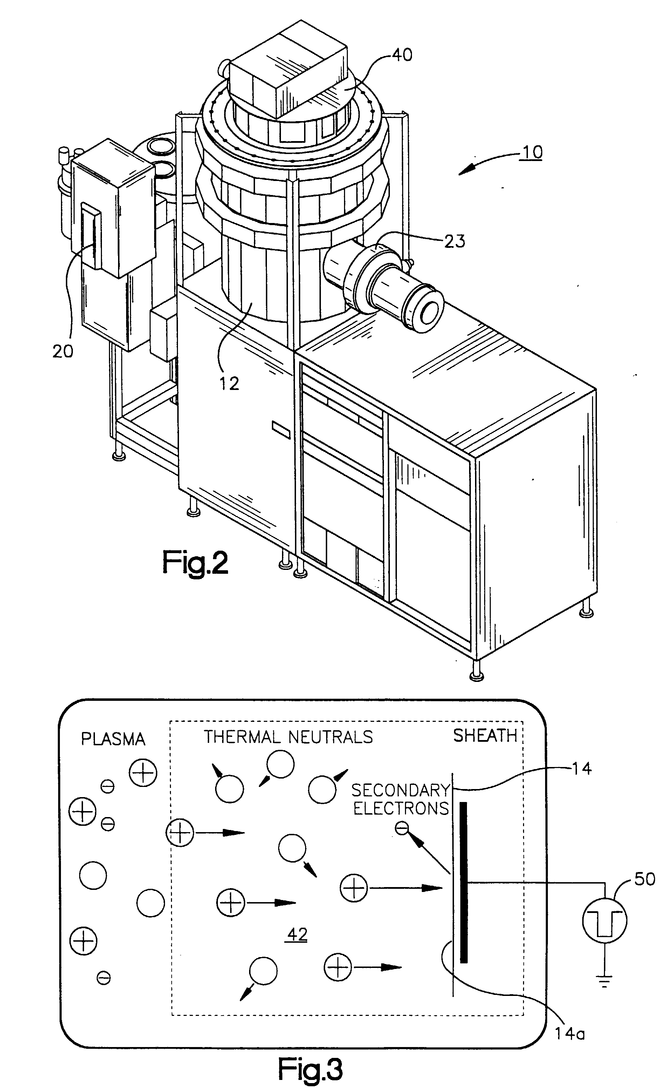

Figures 1 and 2 depict an ion implantation system 10 that includes a generally cylindrical plasma chamber 12 into which one or more generally planar workpieces 14 are inserted for ion treatment of those workpieces. The implantation system 10 includes a loadlock 20 for inserting workpieces into the plasma chamber 12. The loadlock 20 allows the plasma chamber 12 to be maintained at a reduced pressure (in relation to atmospheric pressure) as workpieces are moved into and withdrawn from the chamber 12 through a valve 21 that is opened and closed. A vacuum pump 22 maintains the chamber interior at a reduced pressure that is regulated by a valve 23 located between the chamber 12 and the pump 22.

The plasma chamber 12 depicted in Figure 1 has inner walls that define a chamber interior 24 into which the workpieces 14 are inserted. The workpieces 14 are placed onto and removed from a generally planar conductive platen or support 30. The platen 30 may have any suitable dimensions depending on the size of the workpiece it must support.

An energy source 40 is located at one end of the generally cylindrical process chamber 12. The energy source 40 injects energy into the chamber 12 to produce an ion plasma inside the plasma chamber 12 in a region 42 between the energy source 40 and the wafer support 30. One example of a suitable energy source 40 is an rf coil operating at 13.5 Megahertz that transmits rf energy through a quartz plate 43 that bounds one end of the plasma chamber 12. Other coil energization frequencies are possible and , for example, could include frequencies of about 2.0 Megahertz. Rf energy entering the chamber 12 produces an ion plasma from gas molecules that are pumped into the plasma chamber from an external gas supply 44. The gas pressure in the chamber 12 is maintained in the range of.2 to 5.0 millitorr. As an example, Nitrogen gas can be routed into the chamber and ionized by rf energy entering the chamber from the rf coil. Application of this energy ionizes the gas molecules. Other techniques know for producing an ion plasma in the plasma chamber could be utilized while practicing the present invention.

Once the ion plasma is set up in the region 42 between the support 30 and the quartz plate 43, the ions are accelerated into contact with the workpiece 14. In a preferred embodiment of the present invention, the workpiece is a silicon wafer, generally round in shape, that is placed onto the support 30. The workpiece support 30 is constructed from an electrically conductive material. The ions are positively charged so that application of an electric field of suitable magnitude and direction in the region of the plasma will cause the ions in the plasma to accelerate toward and impact the surface of the silicon wafers. As seen in Figure 1, a modulator 50 supplies voltage pulses 52 that relatively bias the conductive support 30 with respect to conductive inner walls of the chamber 12 to set up an appropriate electric field in the region 42.

Once the wafers 14 are treated, they are removed from the plasma chamber 12 and taken to other processing stations where the treated wafers are further fabricated to form integrated circuits. Such Ion treatment has been conducted on eight inch diameter silicon wafers with good uniformity. Ion implantation using structure similar to that shown in Figure 1 has also been used to treat large surfaces for the fabrication of flat panel displays.

Figure 3 schematically illustrates reactions occurring at a treatment surface 14a of a workpiece 14 as ions from the ion plasma region 42 strike the surface 14a. The collisions illustrated in Figure 3 give rise to both inelastic (production of photons, X-rays, secondary electrons, as well as ion implantation) and elastic (sputtering and reflected particles) reactions. An incident ion can also be trapped in a solid lattice of the workpiece 14. This is the reaction occuring at the surface that results in ion implantation of the workpiece. The ion energy directly affects the probability of implantation occuring and this in turn is mainly determined by the sheath voltage of the plasma, which is dictated by the pulse voltage supplied by the modulator 50. The trapping probability is also affected by gas pressure, since ions may lose part of their energy due to collisions with gas molecules before they reach the surface 14a.

The problems in monitoring a dose delivered by means of the pulsed ion implantation process shown in Figure 1 relate to the makeup of ions in the plasma. If boron triflouride gas (BF₃) is injected into the process chamber 12 from the gas supply 44, during creation of the plasma a variety of atomic and molecular species can result. There can be singly charged boron B⁺, or BF⁺, or BF₂⁺ or atomic fluorine, F or fluorine gas, F₂, for example. For every atom impinging on the negative surface 14a of the workpiece there are several secondary electrons emitted and accelerated. Measuring the dose of a given species implanted into the workpeice 14 by total charge flow monitoring at the surface 14a is not possible because of uncertainty about secondary emission coefficients, the particle mix in the region 42 and actual negative surface area. The particle mix is a function of the electron temperature or energy of the plasma in the chamber. There has heretofore been no effective way to measure this energy by; observationof the plasma.

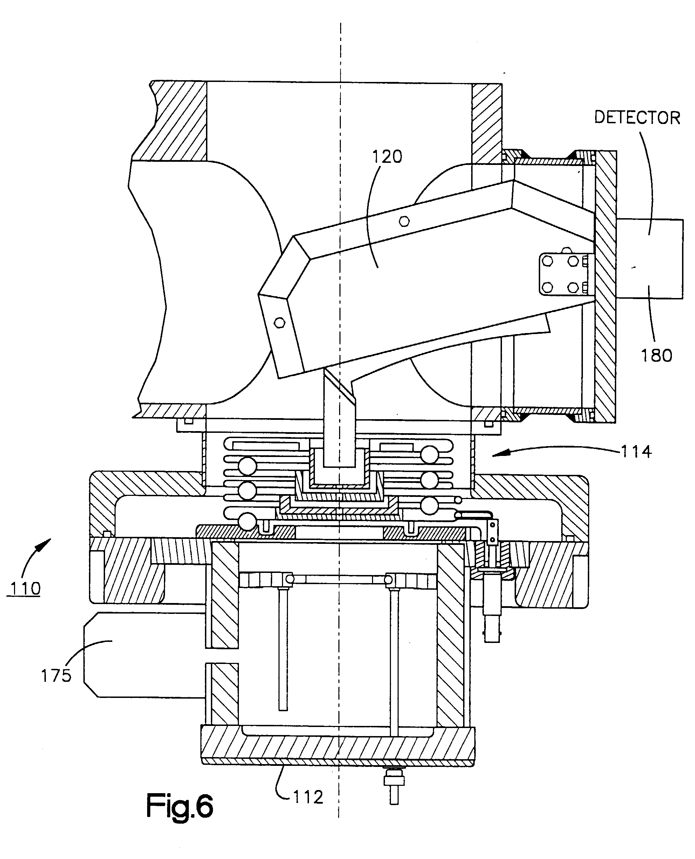

Figure 6 depicts a system 110 that includes a plasma source 112 and structure 114 for forming and shaping an ion beam and directing the ion beam along a beam path away from the plasma source 112. The ions in the ion beam follow a predetermined, desired beam path to a magnet 120 that bends the ions depending on their mass and velocity. A controller (not shown) iteratively changes the magnetic field strength by adjusting the current through the magnets current carrying coils.

Subsequent to this bending of the charged ions, they impact a detector. The magnetic field produced within the magnet acts as a tunable filter that allows certain ion species to pass from the source to the detector depending on the magnetic field strength. Like the plasma of ions in Figures 1 and 2, the ions that exit from the source 112 are made up of different species, but after passing through the magnet the ions that reach the detector are essentially of a single species.

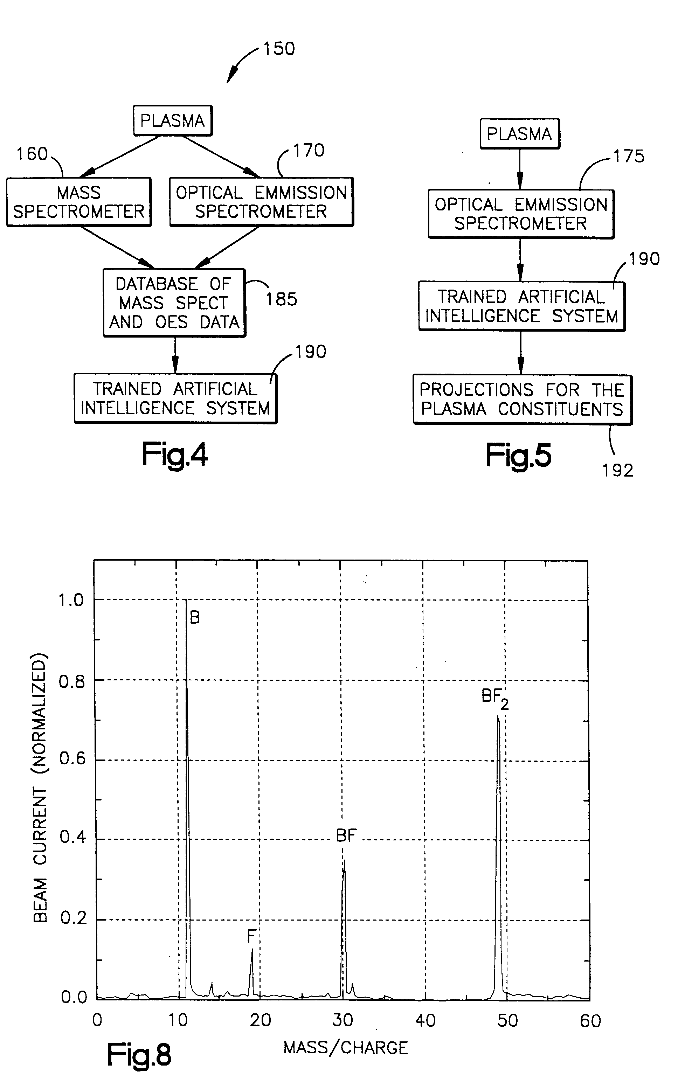

The present invention concerns a system for treating a workpiece surface that takes advantage of a database of information typically stored on a computer to improve the implantation process. The flow charts of Figures 4 and 5 depict the process steps performed during practice of the invention. The ion implanter 10 of Figures 1 and 2 and the source 112 depicted in Figure 6 both include an evacuated region that confines an ion plasma. The flow chart of Figure 4 depicts a process 150 of data gathering by the system of Figure 6. Two process steps 160, 170 are performed on a plasma. A first step is the step of performing a mass analysis 160 of the ions and recording the mass analysis data. This processing step is performed using control over the magnet and its field output as well as a Faraday cup for monitoring beam intensity downstream from the magnet. The step of recording the mass analysis data is performed with the use of a programmable controller such as a general purpose computer. One presently preferred technique for performing the mass analysis is to use a computer to control the operation of the magnet 120 (Figure 6) which causes the ions to bend along controlled arcs or paths to a Faraday cup detector 180.

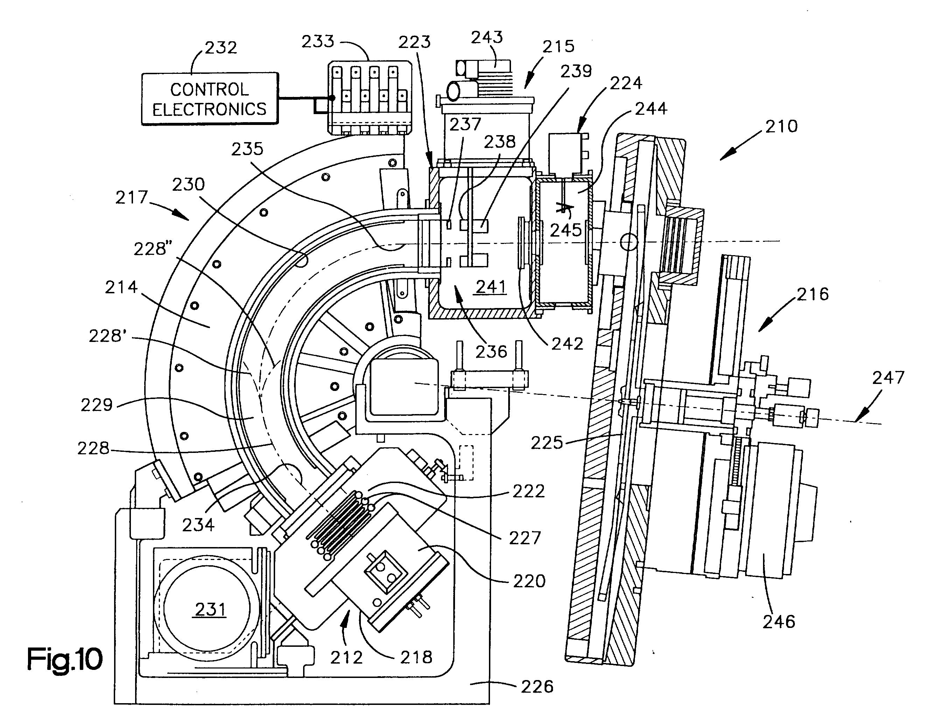

A second step of the process in the Figure 4 depiction is to perform an optical analysis 170 of the ion plasma within the plasma chamber 112 and record this optical analysis data. The optical analysis 170 is performed by use of an optical spectrometer 175 that views the ion plasma inside the plasma chamber 112. These two data gathering steps 160,170 yield two views of the same plasma. A database 185 of records is created in which the mass analysis data and the optical analysis data for plasma concentrations are stored together for subsequent access. The data gathered is stored using a general purpose programmable controller that includes an I/O interface coupled to the magnet 120 and a mass storage device such as disk drive for the storing the database 185. A combination of computer programs including artificial intelligence software 190 executing on the computer is programed to utilize the data on the database 185 to predict parameters of the plasma based on the observed data. In accordance with one aspect of the invention a computer 195 executing the same artifical intelligence software controls at least one parameter of the ion implantation process of the Figure 1 system 10 or alternately can be used to control a process such as the process described below in conjunction with Figure 10.

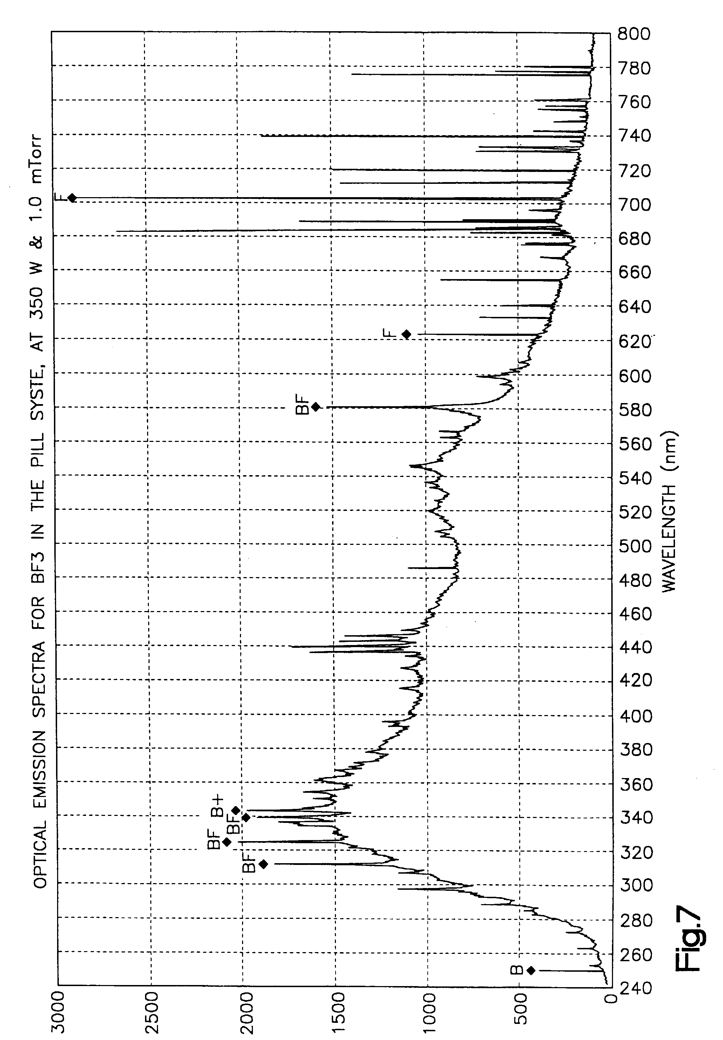

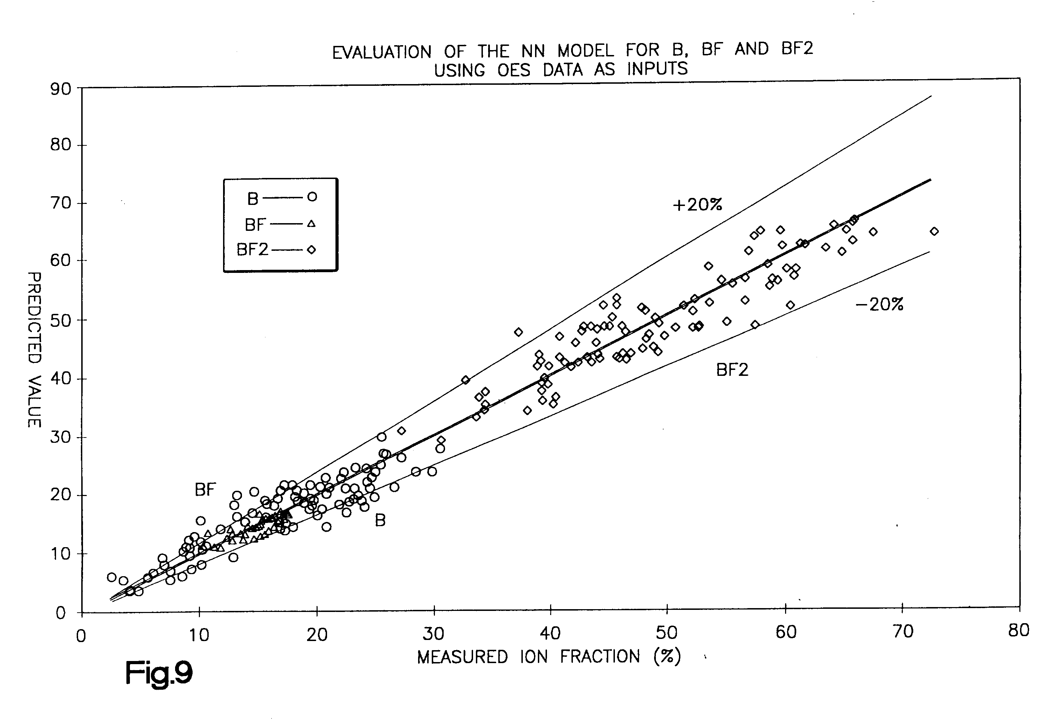

Data used in creating the database 185 is depicted in the graphs of Figures 7 and 8. Figure 7 is a graph for an optical emission of BF₃ plasma (gas concentration fixed) from the optical spectrometer 175. A number of peaks have been labeled with the constituent particle that produced that peak. These peaks are derived from readily identified wavelength data gathered from optical spectroscopy information tabulated by others. The 311 nmeter peak, for example, is a well known spectral peak for a neutrally charged BF molecule. Note, the data on the graph of Figure 7 is based on a specific starting gas (boron tri-fluoride) of a specified pressure and specified power input to the plasma. Changing the gas concentration produces a different characteristic curve of constituents and hence the data of Figure 7 changes. In a preferred data gathering step 170 the pressure is varied and the entire optical analysis over the wavelengths shown in Figure 7 is stored in the database 185 for each gas pressure and excitation energy. Thus, a series of different data tablulations for different gas pressures and different rf powers is produced from the optical emission and mass spectrum analysis.

Figure 8 is a graph showing relative intensities of masses of different constituent components from a plasma source. The ordinate access is a measure of beam current and is collected from the output of detectors (such as Faraday Cups) downstream from the magnet 120 where the ions are bent away from their initial trajectory. The data of Figure 8 is for a fixed gas pressure and excitation energy.

The entire database is populated by forming a plasma at a certain measureable condition of gas density and then varying the magnetic field strength for the plasma under consideration. This will allow data such as the data of Figure 8 to be obtained and stored at the same time the data of Figure 7 is obtained and stored in the database. To gather additional data the gas pressure of the source material injected into the plasma chamber is adjusted and both the mass analysis and optical sprectrum analysis again performed.

The chart of Figure 9 is a graph showing a plot of the results of using the database to predict concentrations of constituent implant ions based upon spectroscopic data and use of the data stored in the database relating to data such as that of Figure 8 relating to constituent makeup from the mass analysis. The Figure 9 data suggests that for a given optical evaluation of an ion plasma, the relative intensities of the constituent spectra is a good predicter (within 20%) of the actual constituent makeup. The constituents monitored in Figure 9 are B⁺, BF⁺ and BF₂⁺ ions.

A preferred process of prediction uses learning algorithms associated with artificial intelligence or neural network software. The process involves the comparisons of data points from the optical analysis with optical analysis of the database that has been previously obtained along with the mass data of Figure 8. By means of a neural network training and the use of the trained algorithm the relative concentrations of the plasma constituents within the source chamber 12 are obtained. A preferred computer program that perfroms the analysis uses techniques such as back-propagation, simulated annealing or genetic algorithms for the neural network training.

Figure 10 discloses an ion implanter wherein ions are extracted from a source to impact workpieces at a workstation. The ion implanter generally designated 210 comprises an ion source 212, a mass analysis magnet 214, a beamline assembly and a target or end station 216. The ion source 212 and the mass analysis magnet 214, along with their respective power supplies, are supported within an implanter housing 217. The ion implanter 210 is a low energy implanter which operates with implant energies of a range .2 - 90 kev and supplies beam currents of about 10milliamps. The beamline assembly 215 is relatively short due to the tendency of a low beam to diffuse (i.e. blow up) during propagation of the beam from the ion source 212 to the end station 216.

The ion source 12 comprises a housing 218 which defines a plasma chamber 220, and an ion extractor assembly 222. The beamline assembly 215 includes a resolver housing 223 and a beam neutralizer 224. The beam neutralizer 224 functions to retard beam blow-up. Downstream from the beam neutralizer 224 is the end station 216, which includes a disk-shaped wafer support 225 upon which wafers to be treated are mounted. The wafer support 225 resides in a target plane which is (generally) perpendicularly orientated to the direction of the implant beam.

The ion source 212 is mounted to an L-shaped frame 226. Ionizable dopant gas, which is obtained either directly in the form of a compressed gas or indirectly from a solid form which has been vaporized, is injected into the plasma chamber 220. Typical source elements are boron (B), phosphorous (P), galluim (Ga), Indium (In), antimony (Sb), and arsenic (As). Most of these source elements are provided in solid form, except boron, which is typically provided in the form of gaseous boron trifluoride or diborane.

Energy is imparted to the ionizable dopant gas to generate ions within the plasma chamber 220. Generally, positive ions are generated, although the present invention is applicable to systems wherein negative ions are generated by the source. The positive ions are extracted through a slit in the plasma chamber 220 by the ion extractor assembly 222 which comprises a plurality of electrodes 227. The electrodes are charged with negative potential voltages, increasing in magnitude as the distance from the plasma chamber slit increases. Accordingly, the ion extractor assembly functions to extract a beam 228 of positive ions from the plasma chamber and accelerate the extracted ions into the mass analysis magnet 214 which is supported by the frame 226.

The mass analysis magnet 214 functions to pass only ions of an appropriate charge-to-mass ratio to the resolver housing 223. The mass analysis magnet 214 is required because the ion source 212, in addition to generating ions of appropriate charge-to-mass ratio, also generates ions of greater or lesser charge-to-mass ratio than that desired.

The mass analysis magnet 214 bounds a curved beam path 229 which is defined by an aluminum beam guide 230, evacuation of which is provided by a vacuum pump 231. The ion beam 228 which propagates along this path is affected by the magnetic field generated by the mass analysis magnet 214. The strength and orientation of this magnetic field is controlled by control electronics 232 which adjusts the electrical current through the field windings of the magnet 214 through magnet connector 233. Partial focusing of the ion beam by the magnet 214 is achieved in the "dispersive " plane (the plane of the curved beam path 229) only by establishing a gradient in the magnetic field (i.e. "Indexing"), or by rotating the entrance or exit poles of the magnet 214.

The magnetic field causes the ion beam 228 to move along the curved beam path 229, from a first or entrance trajectory 234 near the ion source 212 to a second or exit trajectory 235 near the resolving housing 223. Portions 228' and 228" of the beam 228 comprised of ions having an inappropriate charge-to-mass ratio are deflected away from the curved trajectory and into the walls of an aluminum beam guide 230. In this manner, the magnet 214 passes to the resolving housing 223 only those ions in the beam 228 which have the desired charge-to-mass ratio.

The entrance and exit trajectories 234, 235 of the ion beam 228, being in the plane of the curved beam path 229, lie in the dispersive plane. The 'non-dispersive' plane is defined herein as the plane which resides perpendicular to both the dispersive plane and the target plane. Accordingly, the magnet 214 performs mass analysis in the dispersive plane by removing from the beam ions of inappropriate charge-to-mass ratio, and redirecting the beam from the entrance trajectory 234 to the exit trajectory 235 and toward the target plane in which the wafer lies.

The resolving housing 223 contains an electrostatic lens 236, constructed according to the principles of the present invention, which mass resolves and focuses the ion beam 228 output by the magnet 214. The electrostatic lens 236 is constructed in a triple electrode (triode) configuration comprising a terminal electrode pair 237, a suppression electrode pair 238 and a ground or resolving electrode pair 239. The terminal electrode pair 237 is fixedly attached to the housing 217 and operates at the voltage thereof (positive in the acceleration mode and negative in the deceleration mode). Each of the suppression electrodes 238, like each of the pair of ground electrodes 238, is movable toward and away from each other to adjust the gap therebetween. The suppression electrode 237 operates at a negative potential and the resolving electrode 239 is at ground potential (zero volts).

The supression and resolving electrode pairs 238, 239 are collectively referred to as the adjustable lens subassembly 240. The resolving housing 223 defines a chamber 241 in which resides the electrostatic lens 236, as well as a dosimetry indicator such as a Faraday flag 242. The chamber 241 is evacuated by a vacuum pump 243. The adjacent beam neutralizer 224 defines a second chamber 244 which includes an electron shower 245. The electron shower 45 neutralizes the positive charge which would otherwise accumlulate on the target wafer as a result of being implanted by the positively charged ion beam 228.

The disc shaped wafer support 225 at the end station 216 is rotated by a motor 246. The ion beam strikes wafers mounted to the supoport as they move in a circular path. The end station 216 is pivotable along an axis 247 which is generally parallel to the path of the ion beam so that the target plane is adjustable about this axis. In this manner, the angle of ion implantation may be slightly modified from the normal.

The system of Figure 10 implants a variety of different ion species. An optical spectrometer 175 such as the spectrometer positioned to the side of the chamber in Figure 6 can advantageously be used in conjunction with the system of Figure 10. The spectrometer 175 is used to assist in the monitoring of beam cross-contamination. The optical spectrometer output data is gathered as the ion gas components used to create the ions in the chamber are being switched to a different gas. This data is gathered from a view of the plasma within the source chamber 212. Contained within the optical spectrometer data is important information about the constituent within the source. This information is useful since it tells what is being extracted from the source and into the beam.

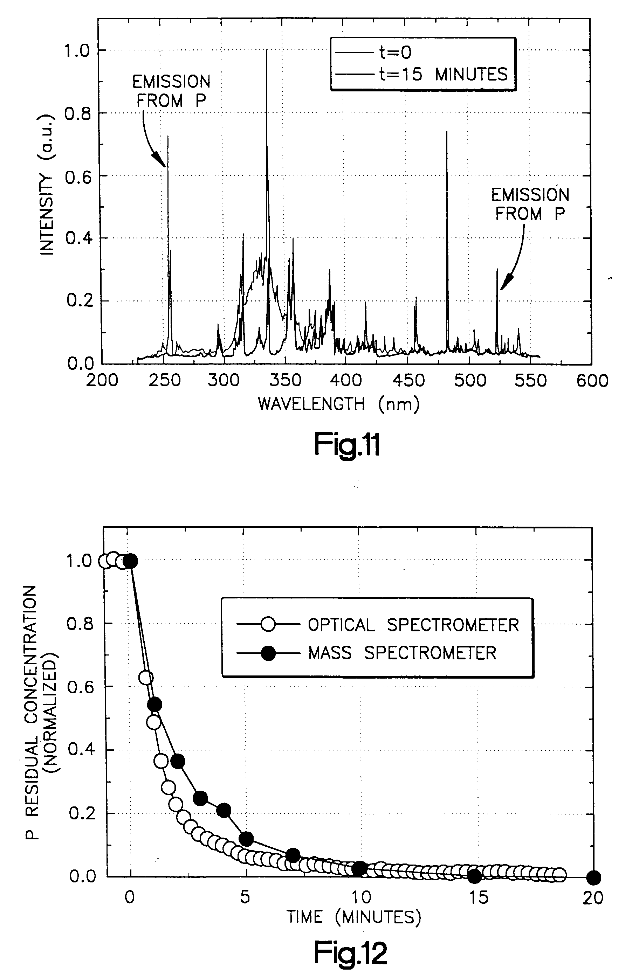

As an example of how this might be used as a species change over cross-contamination monitor, consider the two optical emission spectra shown in Figure 11. These spectra were taken at two different times following a species changeover from phosphine to a different gas source. The t=0 spectrum was taken immediately after the phosphine was turned off and a NF₃ cleaning cycle was begun. Some of the very strong emission lines in the spectrum are attributed to phosphorous atoms and ions, and are highlighted in the figure. Other lines are attributed to nitrogen, fluorine, hydrogen, or molecular combinations of these. The featured phosphine lines clearly undergo dramatic changes in intensity in the fifteen minutes between the two spectra shown in Figure 11. This drop in emission intensity can be shown to correlate well with the drop in P cross-contamination in the beam..

This correlation is shown in Figure 12. The intensity of the line emission in the region around 250 nmeters is measured using an optical spectrometer 175 and is plotted as a function of time following the species change-over and is compared with the actual residual P contamination measured in the beam with the mass spectrometer. The agreement between the two is very good.

The implication of the good agreement is that now the optical spectrometer can be used with confidence to monitor the cross-contamination in the beam that oringinates in the source. Similar correlation monitoring have been done with arsenic and BF₃ and the results from this monitoring is similar.

Additional cross-contamination related uses of the optical spectrometry data include monitoring for residual levels of boron (from BF₃), phosphorous (from PH₃), arsenic (from AsH₃), and germanium (from GeF₄). Additional contamination related applications include monitoring for trace levels of aluminum, or molybdenum, or nickel, generated in the ion source. In principle trace amounts of other contaminant material could be monitored.

Multiple uses of the optical spectroscopy data used in conjunction with ion implantation have been disclosed. While these alternate uses have been described with a degree of particularity, it is the intent that the invention include all modifications and alterations from the disclosed design falling within the spirit or scope of the pending claims.

## Claims

1. A method for use in calibrating an ion implantation process comprising the steps of:
a) producing a concentration of ions in an ion source chamber (112);
b) performing a mass analysis of the concentration of ions and recording mass analysis data;
c) performing an optical analysis of the concentration of ions and recording optical analysis data; and
d) storing a database (185) of records on a storage medium wherein the mass analysis data and the optical analysis data for a given concentration of ions are stored together for subsequent access.

2. The method of claim 1 further comprising the step of performing an ion implanation of a workpiece (14) while performing optical analysis of the ions used to perform the ion implantation and using the results stored in the database (185) to control one or more ion implantation parameters.

3. The method of claim 1 wherein the step of performing the mass analysis is performed by allowing the ions to exit an ion source chamber (112) and travel along an evaculated travel path to a mass analyzer (120).

4. The method of claim 3 wherein the mass analysis is performed by varying the field strength of an analyzing magnet (120) to cause different plasma constituents to be sensed by a detector (180).

5. The method of claim 1 wherein the step of performing an optical analysis yields a series of intensity data values characterizing particle makeup within an ion source chamber.

6. The method of claim 5 wherein the intensity data values for different constituent parts are a function of emitted light wavelength.

7. The method of claim 1 wherein the step of producing a concentration of ions is performed by routing an ionizable gas into the ion chamber source chamber (112) and wherein the steps of performing the mass analysis and performing the optical analysis are performed for different concentrations of the ionizable gas.

8. The process of claim 2 wherein plasma is created by injecting a gas into the ion source chamber (112) and wherein the step of controlling the ion implantation parameter includes adjusting the rate at which gas is injected into the ion source chamber.

9. A method for use in ion implantation of a workpiece by building a database (185) regarding an ion plasma used to perform the ion implantation comprising the steps of:
a) providing a plasma of ions within an ion source chamber (112);
b) causing ions from the plasma to be emitted from the source chamber and move away from the ion source chamber (112) along an ion travel path to an analyzing magnet (120);
c) performing an optical analysis of an ion plasma within the ion source chamber and recording optical analysis data;
d) adjusting a magnetic field produced by the analyzing magnet (120) to perform a mass analysis on the ions moving away from the source chamber; and
e) creating a database (185) of plasma characteristics as a function of data gathered during the optical analysis of the ion plasma and the mass analysis of ions emitted from the ion source chamber and storing the database on a data storage device.

10. An ion implantation system for causing ions to impact an implantation surface of one or more workpieces (14) comprising:
a) a process chamber (12) defining a chamber interior into which one or more workpieces can be inserted for ion treatment;
b) an energy source (40) for setting up an ion plasma within the process chamber;
c) a support (30) for positioning one or more workpieces within an interior region of the process chamber so that an implantation surface of the one or more workpieces is positioned within the ion plasma;
d) an optical sensor (175) for monitoring the ion plasma and for providing optical analysis data; and
e) a data store (185) for storing data correlating optical analysis data obtained from the optical sensor with a parameter of the ion plasma within the process chamber to allow adjustment of that parameter based upon an output from the optical sensor (175).

11. The apparatus of claim 10 further comprsing a data gathering system comprising a source (112) for providing an ion plasma and both a mass analyser (120, 180) and a spectroscopy analyser (175) for building the data for the data store (185).

12. The apparatus of claim 11 wherein the data gathering system includes a mass analyser which comprises a magnet (120) and a detector (180) for detecting ions that have been bent analyzed by the magnet.

13. The apparatus of claim 12 wherein the data gathering system includes a computer for controlling a magnetic field set up by the magnet and for storing data gathered by the detector.

14. The apparatus of claim 10 additionally comprising a programmable controller (190) for performing an analysis on data gathered from the optical sensor for use in adjusting the parameter of the plasma.

15. The apparatus of claim 14 additionally comprising a gas source (44) and wherein the parameter that is adjusted based upon the optical sensor output is a concentration of gas within the process chamber.

16. An ion implantation system (10, 210) for causing ions to impact an implantation surface of one or more workpieces (14) comprising:
a) an implantation chamber (12, 216) defining a chamber interior into which one or more workpieces can be inserted;
b) a source (40, 212) for providing a concentration of charged ions within the implantation chamber;
c) a support (30, 225) for positioning one or more workpieces within an interior region of the implantation chamber so that an implantation surface of the one or more workpieces faces the source for causing the ions to impact the implantation surface;
d) an optical analysis sensor (175) for monitoring the concentration of ions in the region near the workpiece implantation surface and for providing optical analysis data of said concentration of ions;
e) a data store (185) for storing data correlating optical analysis data obtained from the optical analysis sensor with previously gathered parameters of the ions based on other optical analysis sensor data; and
f) an implantation controller (190) for adjusting the ion implantation process based upon the optical sensing of the ions.

17. A method for use in performing an ion implantation process comprising the steps of:
a) producing a concentration of ions of a particular species in an ion source chamber (12, 212) by injecting a first ion source material into the chamber;
b) using the concentration of ions of said particular species to treat one or more workpieces;
c) stopping the injection of the ion source material into the chamber while continuing to ionize ion source material within the ion source chamber;
d) performing an optical analysis on the materials within the ion source chamber to determine when a concentration of the first ion source material has dropped to a specified lower level; and
e) injecting a second ion source material into the ion source chamber (12, 212) to begin production of a second ion species within the ion source chamber for use in treating additional workpieces.

18. A method for use in monitoring constituents of an ion implantation process chamber comprising the steps of:
a) producing a concentration of ions of a particular species in an ion source chamber (12, 212) by injecting an ion source material into the process chamber;
b) treating one or more workpieces by causing ions from the concentration of ions of said particular species to treat one or more workpieces (14);
c) performing an optical analysis on the materials within the ion source chamber (12, 212) to determine when a concentration of an undesirable material within the ion chamber has risen to too high a level; and
d) stopping treatment of the workpieces and lowering a concentration of the undesirable material from the source chamber before resuming treatment of the workpieces.

19. The method of claim 18 wherein the step of treating the one or more workpieces is performed by inserting the workpieces (14) into the ion source chamber (12, 212).

20. The method of claim 18 wherein the step of treating the one or more workpieces is performed by extracting the ions from the ion source chamber along an evacuated path (215) to an ion implantation chamber.

21. An ion implantation system for causing ions to impact an implantation surface of one or more workpieces comprising:
a) a process chamber (12) defining a chamber interior into which ion source material is added;
b) an energy source (40) for setting up an ion plasma within the process chamber by ionizing the ion source material;
c) an optical sensor (175) for monitoring the ion plasma and for providing optical analysis data; and
d) a programmable controller (190) for correlating optical analysis data obtained from the optical sensor with a parameter of the constituents within the process chamber.

22. The apparatus of claim 21 wherein the programmable controller senses a decreasing amount of the ion source material within the process chamber to control a changeover from one ion implantation constituent to a second ion implantation constituent.

23. The apparatus of claim 21 additionally comprising a gas source (44) and wherein the parameter that is adjusted based upon the optical sensor output is a concentration of gas within the process chamber.
